# EUROPEAN PATENT APPLICATION

(11) **EP 4 585 580 A1**
(43) Date of publication of application: **16.07.2025**
(21) Application number: 23863217.8
(22) Date of filing: 06.09.2023
(51) Int. Cl.: C04B 35/581, C04B 41/87, C23C 16/34

(54) **CERAMIC STRUCTURE**

(30) Priority: 09.09.2022 JP 2022143863
(71) Applicant: Kyocera Corporation, Kyoto-shi, Kyoto 612-8501 (JP)
(72) Inventor: IIDA, Mami, Kyoto-shi, Kyoto 612-8501 (JP); SHIMA, Kohei, Kyoto-shi, Kyoto 612-8501 (JP); TOYODA, Satoshi, Kyoto-shi, Kyoto 612-8501 (JP); OGAWA, Hiromitsu, Kyoto-shi, Kyoto 612-8501 (JP)
(74) Representative: Viering, Jentschura & Partner mbB Patent- und Rechtsanwälte
(86) International application number: PCT/JP2023/032556
(87) International publication number: WO 2024/053679

(57) **Abstract**

The ceramic structure includes a first layer containing a first crystal particle and a second layer positioned on the first layer and containing a second crystal particle. The first crystal particle and the second crystal particle contain at least one metal element selected from the group consisting of Al, Si, Ti, Cr, Zr, and Y, and at least one non-metallic element selected from the group consisting of N, C, and B. The first crystal particle and the second crystal particle are identical compounds. When a half-width of a peak of a Miller index of a maximum intensity of the first crystal particle in an X-ray diffraction of the first layer is W1 and a half-width of a peak same as that of the Miller index of the second crystal particle in an X-ray diffraction of the second layer is W2, 9 × W1 > W2 > W1 is satisfied.

## Description

### TECHNICAL FIELD

Embodiments of the present disclosure relate to a ceramic structure.

### BACKGROUND OF INVENTION

As described in Patent Document 1, a ceramic structure including a thin film made by chemical vapor deposition (CVD) has been known. Patent Document 2 describes that a film made by a chemical vapor deposition method is dense, includes no voids, and has high smoothness. Patent Document 3 describes that a content of pores is less than 3 area%.

### CITATION LIST

### PATENT LITERATURE

Patent Document 1: JP S63-040314 A
Patent Document 2: JP H07-180057 A
Patent Document 3: JP 2020-053579 A

### SUMMARY

The ceramic structure according to an aspect of embodiments includes a first layer containing a first crystal particle, and a second layer positioned on the first layer and containing a second crystal particle. The first crystal particle and the second crystal particle each contain at least one metal element selected from the group consisting of Al, Si, Ti, Cr, Zr, and Y, and at least one non-metallic element selected from the group consisting of N, C, and B. The first crystal particle and the second crystal particle are identical compounds. When a half-width of a peak of a Miller index of a maximum intensity of the first crystal particle in an X-ray diffraction of the first layer is defined as W1, and a half-width of a peak, the peak being the same as that of the Miller index of the second crystal particle, in an X-ray diffraction of the second layer is defined as W2, 9 × W1 > W2 > W1 is satisfied.

### ADVANTAGEOUS EFFECT

An aspect of embodiments provides a ceramic structure having excellent durability.

### BRIEF DESCRIPTION OF THE DRAWINGS

FIG. 1 is a cross-sectional view illustrating an example of a ceramic structure according to an embodiment.
FIG. 2 is an enlarged view of a region A illustrated in FIG. 1.
FIG. 3 is a cross-sectional view illustrating another example of a ceramic structure according to an embodiment.
FIG. 4 is a cross-sectional view illustrating another example of a ceramic structure according to an embodiment.
FIG. 5 is a cross-sectional view illustrating another example of a ceramic structure according to an embodiment.
FIG. 6 is a flowchart illustrating an example of a manufacturing method of a ceramic structure according to an embodiment.

### DESCRIPTION OF EMBODIMENTS

In the structure described above, there is room for further improvement in terms of enhancing durability.

Expectations of a ceramic structure having excellent durability exist.

Hereinafter, embodiments of a ceramic structure disclosed in the present application will be described with reference to the accompanying drawings. Note that the disclosure is not limited by the following embodiments.

### Embodiments

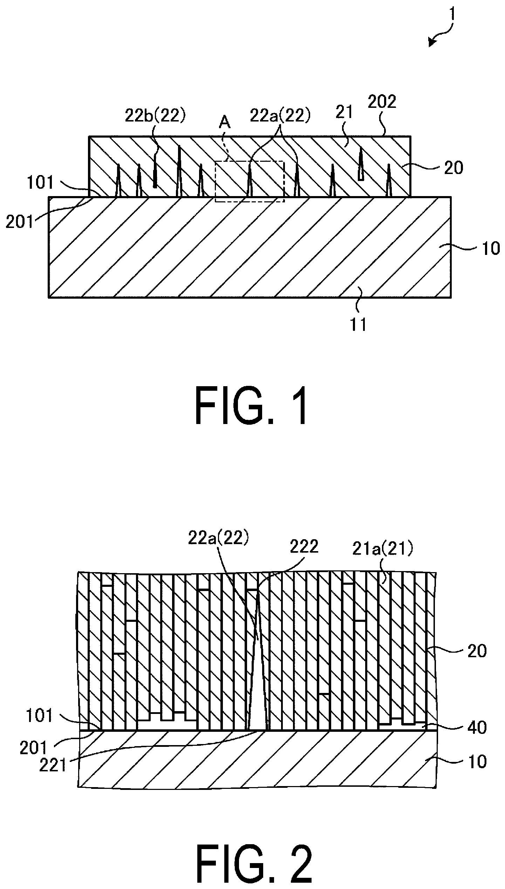

FIG. 1 is a cross-sectional view illustrating an example of a ceramic structure according to an embodiment. In the example illustrated in FIG. 1, the ceramic structure 1 includes a first layer 10 and a second layer 20. The first layer 10 contains a first crystal particle 11. The second layer 20 contains a second crystal particle 21. The first crystal particle 11 and the second crystal particle 21 each contain at least one metal element selected from the group consisting of Al, Si, Ti, Cr, Zr, and Y, and at least one non-metallic element selected from the group consisting of N, C, and B.

The first layer 10 may contain equal to or greater than 50 area% of the first crystal particle 11. The first layer 10 may contain equal to or greater than 80 area% of the first crystal particle 11. The first layer 10 may contain equal to or greater than 90 area% of the first crystal particle 11.

The second layer 20 may contain equal to or greater than 50 area% of the second crystal particle 21. The second layer 20 may contain equal to or greater than 80 area% of the second crystal particle 21. The second layer 20 may contain equal to or greater than 90 area% of the second crystal particle 21.

An amount of the second crystal particle 21 contained in the second layer 20 may be more than an amount of the first crystal particle 11 contained in the first layer 10. The first crystal particle 11 and the second crystal particle 21 are identical compounds. The first crystal particle 11 and the second crystal particle 21 may be AlN, Si₃N₄, SiC, TiN, TiC, ZrN, ZrB, and/or YN. In particular, the first crystal particle 11 may be AlN. Being an identical compound means that, for example, a main constituent includes Al and N in a case of AlN, and only requires identification as AlN by XRD. For example, a ratio of the contained Al and N does not need to be 1:1. The first crystal particle 11 and the second crystal particle 21 may have different contents of Al.

When a half-width of a peak of a Miller index of a maximum intensity of the first crystal particle 11 in an X-ray diffraction of the first layer 10 is W1 and when a half-width of a peak same as that of the Miller index of the second crystal particle 21 in an X-ray diffraction of the second layer 20 is W2, 9 × W1 > W2 > W1 is satisfied. The half-width is known as an index for evaluation of crystallinity of a crystal. When identical compounds are compared, a crystal having a smaller half-width has a higher crystallinity. That is, W2 > W1 means that a degree of crystallinity of the second crystal particle 21 is lower than a degree of crystallinity of the first crystal particle 11. 9 × W1 > W2 means that the half-width of W2 is smaller than 9 times the half-width of W1. The relationship between W1 and W2 may be 8.5 × W1 > W2. The relationship between W1 and W2 may be 8.0 × W1 > W2. The relationship between W1 and W2 may be 6.9 × W1 > W2.

W1, W2, and W3 described below may be measured according to the following methods. Low-angle incidence measurement is performed by using a thin film X-ray diffractometer X'Pert PRO-MRD (DY1878), available from Panalytical. The optical system includes an X-ray mirror (automatic insertion attenuation plate, mask 5, solar slit 0.02 rad, slit 1/8), a plate-shaped collimator, a tubular lamp of CuKα, an X-ray of 45 kV, 40 mA, 2θ scan of 10° to 100°, an incident angle of 0.1°, a step of 0.02°, and time of 4.0 seconds/step. For example, whether or not the crystal particle is AlN can be determined based on JCPDS No. 00-025-1133.

In the example illustrated in FIG. 1, the first layer 10 is a base and, for example, may have a substantially circle sheet form. In the example illustrated in FIG. 1, the second layer 20 is positioned on the base (first layer 10), and the second layer 20 may be in contact with the base (first layer 10).

For example, the base (first layer 10) contains ceramics such as aluminum nitride (AlN) as a main constituent. For example, the first layer 10 may further contain aluminum oxide (Al₂O₃), yttria (Y₂O₃), and/or the like as a main constituent. The first layer 10 may be a sintered body obtained by firing raw material powder. When the first layer 10 is a sintered body, the degree of crystallinity of the first crystal particle 11 is high. Such a configuration can provide a ceramic structure having excellent durability.

The first crystal particle 11 and the second crystal particle 21 may be hexagonal crystals. In a case of the hexagonal crystals, crystals have anisotropy. By utilizing the anisotropy, a ceramic structure having excellent durability can be provided.

The first crystal particle 11 and the second crystal particle 21 may be AlN, and a difference between the W1 and the W2 (W2 - W1) described above may be equal to or greater than 0.1° and equal to or less than 0.6°. Such a configuration can provide a ceramic structure having excellent durability because a difference of the physical property values between the first layer 10 and the second layer 20 can become small with the second layer 20 different from the first layer 10 provided.

The second layer 20 may have a gap 22 positioned in an inner portion of the second layer 20. The gap 22 may be long in the thickness direction of the second layer 20, and both ends of the gap 22 in the thickness direction may be closed. The gap 22 may have a first gap 22a having an end in contact with the first layer 10 in the thickness direction and/or a second gap 22b having the end apart from the first layer 10. For example, such a configuration can reduce residual stress in an inner portion of the second layer 20. Thus, peeling between the first layer 10 and the second layer 20 and/or cracks are less likely to occur, and durability of the ceramic structure 1 improves.

The gap 22 may have a long shape having a side in a thickness direction longer than a side in a width direction of the second layer 20. The gap 22 may include both ends closed in the thickness direction of the second layer 20. That is, the gap 22 is positioned in between the first surface 201, which is facing the first layer 10, of the second layer 20 and the second surface 202 positioned on an opposite side from the first surface 201. The gap 22 is not exposed to the second surface 202, which is an interface between the second layer 20 and an outside. Thus, the second layer 20 has predetermined durability even when the second layer 20 includes the gap 22 in an inner portion. The gap 22 is not a lattice defect or the so-called nanovoid that may exist in the second crystal particle 21. For example, a width of the gap 22 may be equal to or greater than 0.01 µm. For example, the width of the gap 22 may be equal to or greater than 0.05 µm. For example, the width of the gap 22 may be equal to or less than 1 µm. For example, the width of the gap 22 may be equal to or less than 0.5 µm. For example, a length of the gap 22 may be equal to or greater than 0.2 µm. For example, the length of the gap 22 may be equal to or greater than 0.5 µm. For example, the length of the gap 22 may be equal to or less than 5 µm. For example, the length of the gap 22 may be equal to or less than 1 µm.

For example, presence of the gap 22 can be confirmed by observation using an electron microscope. For example, a proportion of area occupied by the gap 22 of the second layer 20 may be equal to or greater than 0.2 area%. For example, the proportion of area occupied by the gap 22 may be equal to or greater than 1 area%. For example, the proportion of area occupied by the gap 22 may be equal to or less than 5 area%. For example, the proportion of area occupied by the gap 22 may be equal to or less than 3 area%. Measurement of the proportion of area occupied by the gap 22 of the second layer 20 may be performed, for example, at a center portion of a cross section after the cross section of the second layer 20 has been subjected to mirror finishing. Observation by an electron microscope may be performed at a multiplication factor of 1000 to 50000. The electron microscope may be JSM7900F, available from JEOL Ltd., and the acceleration voltage may be 5.0 kV. The proportion of area of the gap 22 may be calculated by using image analysis software IMAGE Pro 10, available from Media Cybernetics, based on the SEM photograph. At this time, the SEM photograph may be subjected to binary conversion by the Ward's method, and the calculation may be performed by using the image undergone the binary conversion.

The gap 22 may include a first gap 22a and a second gap 22b. The first gap 22a is a gap 22 having a bottom end in contact with the surface 101 of the first layer 10, the bottom end being an end in the thickness direction of the second layer 20. The second gap 22b is a gap 22 having an end apart from the surface 101 of the first layer 10. The second layer 20 may contain both of the first gap 22a and the second gap 22b in the inner portion or may contain one of these.

Details of the second layer 20 will be further described using FIG. 2. FIG. 2 is an enlarged view of a region A illustrated in FIG. 1.

The second crystal particle 21 contained in the second layer 20 may include a pillar-shaped crystal 21a. For example, the pillar-shaped crystal 21a extends in a direction intersecting the surface 101 of the first layer 10. That is, the pillar-shaped crystal 21a extends in the thickness direction of the second layer 20. The second layer 20 may include a plurality of pillar-shaped crystals 21a arranged along the surface 101 of the first layer 10. When the second crystal particle 21 includes the pillar-shaped crystal 21a, thermal conductivity in the thickness direction of the second layer 20 improves. Accordingly, variation of the temperature in the thickness direction of the second layer 20 decreases, and the second layer 20 has improved durability.

The width of the gap 22, that is, a length of the gap 22 in a direction along the surface 101 of the first layer 10, may be smaller at a second end portion 222 apart from the first layer 10 than at a first end portion 221 in the thickness direction positioned on the first layer 10 side. Accordingly, the gap 22 is less likely to be expanded as a crack in a direction from the second end portion 222 to the second surface 202. Thus, durability of the ceramic structure 1 including the second layer 20 improves. The gap 22 may be positioned in between adjacent pillar-shaped crystals 21a. The gap 22 may be larger or smaller than the pillar-shaped crystal 21a.

A space 40 may be provided between the first layer 10 and the second layer 20. The space 40 means a space extending along the surface 101 of the first layer 10. More specifically, in a cross-sectional view, a length of an imaginary line segment between both ends of the space 40 in a direction along the surface 101 is longer than a maximum height of the space 40 in a direction intersecting with the surface 101. More specifically, the length of the imaginary line segment between both ends of the space 40 in the direction along the surface 101 is equal to or greater than 5 times, and preferably equal to or greater than 10 times, longer than the height of the space 40 in the direction intersecting with the surface 101.

The second layer 20 may have a larger porosity in a first portion that is a portion closer to the first layer 10 than a second portion that is a portion apart from the first layer 10 compared to the first portion. Thus, a coefficient of thermal conductivity of the first portion can be smaller than a coefficient of thermal conductivity of the second portion. Thus, when thermal shock is applied to the ceramic structure 1 from the second layer 20 side, rapid change in temperature difference between the first layer 10 and the second layer 20 can be suppressed. Accordingly, durability against the thermal shock of the ceramic structure 1 improves. For example, the first portion may be a region including the first surface 201 in the SEM image described above. For example, the second portion may be a region including the second surface 202 in the SEM image described above. The first portion and the second portion may be partially overlapped.

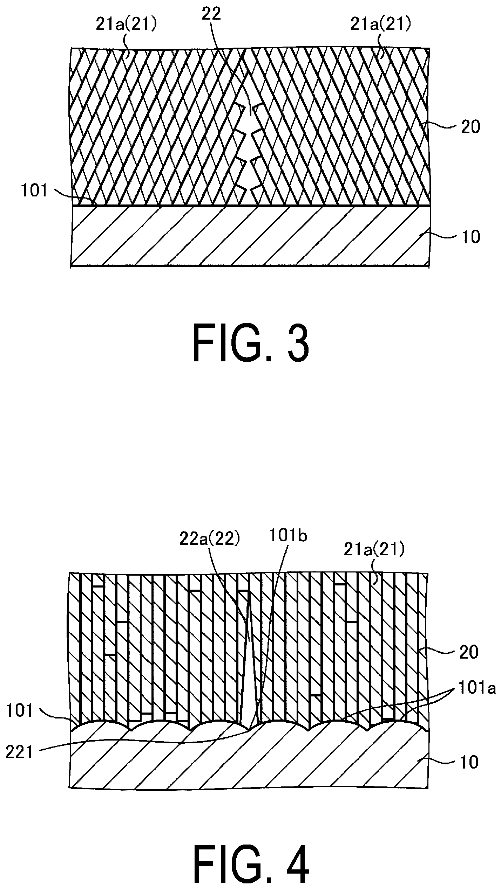

FIGs. 3 to 5 are cross-sectional views illustrating other examples of ceramic structures according to embodiments. As illustrated in FIG. 3, the second layer 20 may include a plurality of pillar-shaped crystals 21a inclined with respect to the surface 101 of the first layer 10. The gap 22 may be positioned in between the plurality of pillar-shaped crystals 21a that are adjacent. Accordingly, when a tip of the pillar-shaped crystal 21a is in contact with the gap 22, residual stress of the pillar-shaped crystal 21a decreases, and thus durability of the second layer 20 improves. Although the first gap 22a is illustrated as an example of the gap 22 in FIG. 3, the second gap 22b may be employed.

As illustrated in FIG. 4, the first layer 10 may include recesses and protrusions on the surface 101 facing the second layer 20. The gap 22 may have the first end portion 221 that is an end in the thickness direction positioned in a recessed portion 101b of the first layer 10. This prevents expansion of the gap 22 in a direction along the surface 101 of the first layer 10 in the first end portion 221. As a result, formation of cracks in pillar-shaped crystals 21a adjacent to the first end portion 221 is suppressed, and durability of the ceramic structure 1 improves. The same and/or similar applies to a case where the gap 22 is positioned on a protruding portion 101a of the first layer 10. Although the first gap 22a is illustrated as an example of the gap 22 in FIG. 4, the second gap 22b may be employed. The gap 22 may be positioned on a protruding portion 101a of the first layer 10. Although an example in which the plurality of pillar-shaped crystals 21a is extending along the thickness direction of the second layer 20 is described in FIG. 4, the plurality of pillar-shaped crystals 21a may extend inclining with respect to the thickness direction of the second layer 20 to correspond to recesses and protrusions of the surface 101 of the first layer 10.

A volume resistivity of the second layer 20 at 25°C may be larger than a volume resistivity of the first layer 10 at 25°C. A volume resistivity of the second layer 20 at 500°C may be larger than a volume resistivity of the first layer 10 at 500°C. The volume resistivity of the second layer 20 at 25°C may be equal to or greater than 1 × 10¹² Ω·m. The volume resistivity of the second layer 20 at 500°C may be equal to or greater than 1 × 10⁵ Ω·m.

The volume resistivity of the second layer 20 and the first layer 10 may be measured by a three-point probe method in accordance with JIS C 2141:1992.

The ceramic structure 1 may include an electrically conductive layer in an inner portion. The electrically conductive layer may have a function as a heater. The electrically conductive layer may also have an absorbing function. For example, the electrically conductive layer may include W, Mo, Ni, and Pt as a metal.

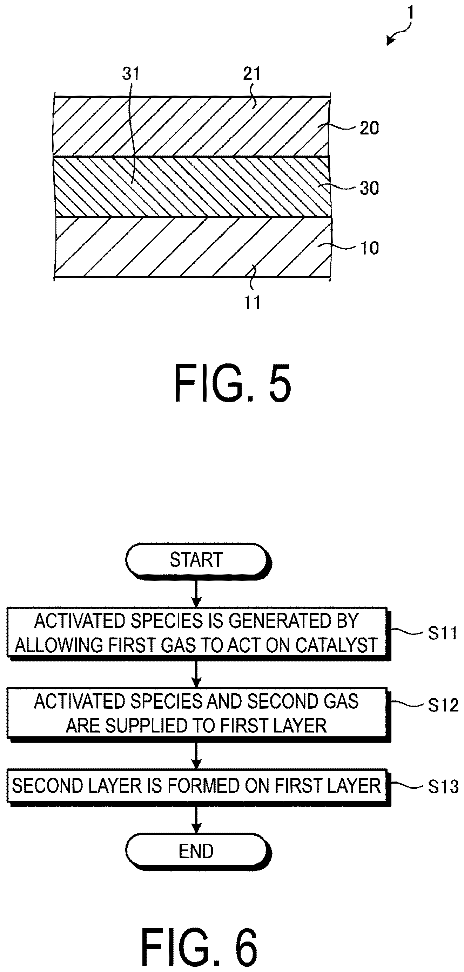

As illustrated in FIG. 5, the ceramic structure 1 may further include a third layer 30 positioned in between the first layer 10 and the second layer 20. The third layer 30 contains a third crystal particle 31 that is an identical compound with the second layer 20. The third layer 30 may contain a third crystal particle 31 as a main constituent. The third layer 30 may contain equal to or greater than 50 area% of the third crystal particle 31. The third layer 30 may contain equal to or greater than 80 area% of the third crystal particle 31. The third layer 30 may contain equal to or greater than 90 area% of the third crystal particle 31.

When a half-width of a peak of the third crystal particle 31, the peak being same as that of the Miller index of the second crystal particle 21, in an X-ray diffraction of the third layer 30 is W3, W2 > W3 may be satisfied. 9 × W3 > W2 may be satisfied. The relationship between W3 and W2 may be 8.5 × W3 > W2. The relationship between W3 and W2 may be 8.0 × W3 > W2. The relationship between W3 and W2 may be 6.9 × W3 > W2. Such a configuration can provide an effect that is the same as and/or similar to the cases of the first layer 10 and the second layer 20.

### Method for Manufacturing Ceramic Structure

An example of the method for manufacturing the ceramic structure will be described with reference to FIG. 6. FIG. 6 is a flowchart illustrating an example of a manufacturing method of a ceramic structure according to an embodiment.

A sintered body containing from 90 mass% to 99.9 mass% of disk-like AlN is prepared as a base (first layer 10). Then, a second layer containing AlN as a main constituent is formed on a surface of this base by the following procedure. First, a catalyst is allowed to act on a first gas (Step S11). The first gas to be used is preferably a gas containing nitrogen. Examples of the first gas to be used include ammonia. For example, the catalyst to be used can be tungsten. For example, when the catalyst acts on the first gas in an environment at approximately 1600°C to 2200°C, the first gas is decomposed by the catalytic action, and multiple activated species are formed.

Then, the activated species generated in Step S11 and a second gas are supplied to the first layer 10 (Step S12). For example, the second gas to be used can be trimethylaluminum.

Next, a second layer 20 is formed on the first layer 10 (Step S13). The first layer 10 may be heated as necessary. For example, setting of the temperature of the first layer 10 can be at approximately 420°C to 1000°C, and particularly approximately at 600°C to 700°C. For example, the film formation time can be from 0.5 hours to 20 hours based on the desired thickness. For example, depending on the set temperature and the like during the film formation, a ceramic structure 1 including a second layer 20 having a different crystalline structure provided on the first layer 10 can be obtained.

### EXAMPLES

An AlN sintered body containing 98 mass% of AlN crystal was prepared as a main phase. This AlN sintered body was processed as a first layer having a size of 100 mm square. An inner portion of this AlN sintered body included an electrically conductive layer containing W as a metal. This electrically conductive layer was in a heater pattern. On one surface of the first layer, a second layer was then formed by using ammonia as a first gas, trimethylaluminum as a second gas, and tungsten as a catalyst. The film-forming temperature is listed in Table 1. W1 and W2 of the obtained ceramic structure was measured. W1 and W2 are shown in Table 1. As one Comparative Example, the AlN sintered body described above including no second layer was used. In a case of this sample, the portion corresponding to the first layer and the portion corresponding to the second layer had the same half-width.

Using a cross section of the second layer of the obtained ceramic structure, presence of gaps, a shape of a gap, and the like were observed. As one Comparative Example, a sample including the portions corresponding to the first layer and the second layer produced by using sintered bodies was also listed in Table 1. Table 1 shows film-forming temperatures and measured values described above. In Table 1, a blank indicates unmeasured or uncalculated.

Each of the obtained samples was subjected to mirror polishing and then to plasma etching resistance test using a CF₄ gas, and thus etching rate was evaluated. A larger etching rate indicates inferior plasma etching resistance.

### [Table 1]

**Table 1**

| Sample No. | Film-forming temperature (°C) | Film-forming rate | Surface roughness before plasma resistance test | Surface roughness after plasma resistance test | Change in surface roughness Ra (µm) | W1 (°) | W2 (°) | W2/W1 | Gap (area%) | Average value of major axis (µm) | Average value of minor axis (µm) |
|---|---|---|---|---|---|---|---|---|---|---|---|
| 1 | Sintered body | - | 0.350 | 0.400 | 0.05 | 0.07 | 0.07 | 1.0 | 0 | 0 | 0 |
| 2 | 350 | 3.6 | | | | 0.07 | 0.78 | 11.1 | | | |
| 3 | 400 | 13.0 | | | | 0.07 | 0.68 | 9.7 | | | |
| 4 | 600 | 260.0 | 0.045 | 0.055 | 0.009 | 0.07 | 0.48 | 6.9 | 1.40 | 0.94 | 0.10 |

In a case of Sample No. 1 that was Comparative Example including the portions corresponding to the first layer and the second layer produced by using sintered bodies, the content of AIN in the portions corresponding to the first layer and the second layer was 98 mass% while the first layer was composed of approximately 100 mass% of AIN. The relationship between W1 and W2 was W1 = W2 and could not satisfy W2 > W1. Sample No. 1 had a larger surface roughness than that of Sample No. 4 that was Example even though Sample No. 1 was mirror-polished. This is considered to be because of shedding of crystals constituting the sintered body during mirror polishing for Sample No. 1. Sample No. 1 had a larger surface roughness after the etching test than that of Sample No. 4 that was Example. Sample No. 1 had a larger change in the surface roughness before and after the etching test than that of Sample No. 4. This is considered to be because of shedding of crystals present on the surface of the sintered body during the etching test. Such shedding can be a problem in a case where the ceramic structure is used as a member for a semiconductor manufacturing device.

Cases of Sample Nos. 2 and 3, in which the film-forming temperature was equal to or lower than 400°C, experienced significantly slow film-forming speed and were not at levels suitable for mass production. Sample Nos. 2 and 3 could not satisfy 9 × W1 > W2. Sample Nos. 2 and 3 that did not satisfy 9 × W1 > W2 had low durability.

On the other hand, Sample No. 4 that was Example had excellent surface texture by the mirror polishing. Sample No. 4 also had excellent durability in the etching test. Sample No. 4 also had remarkably excellent surface roughness after the etching, and it is conceived that shedding was suppressed.

In an embodiment, (1) a ceramic structure includes
a first layer containing a first crystal particle, and
a second layer positioned on the first layer, the second layer containing a second crystal particle,
the first crystal particle and the second crystal particle each containing:
   at least one metal element selected from the group consisting of Al, Si, Ti, Cr, Zr, and Y; and
   at least one non-metallic element selected from the group consisting of N, C, and B,
   the first crystal particle and the second crystal particle being identical compounds,
   wherein when a half-width of a peak of a Miller index of a maximum intensity of the first crystal particle in an X-ray diffraction of the first layer is defined as W1, and a half-width of a peak, the peak being the same as that of the Miller index of the second crystal particle, in an X-ray diffraction of the second layer is defined as W2,
   9 × W1 > W2 > W1 is satisfied.

(2) In the ceramic structure (1) described above, the first crystal particle and the second crystal particle may be hexagonal crystals.

(3) In the ceramic structure (1) or (2) described above, the first crystal particle and the second crystal particle may be AlN, and
a difference between the W1 and the W2 (W2 - W1) may be equal to or greater than 0.1° and equal to or less than 0.6°.

(4) In any one of the ceramic structures (1) to (3) described above, the second layer may include a gap positioned in an inner portion of the second layer, the gap may be long in a thickness direction of the second layer, and both ends in the thickness direction may be closed,
the gap may be including at least one selected from the group consisting of: a first gap having an end in contact with the first layer in the thickness direction; and a second gap having the end apart from the first layer.

(5) In the ceramic structure (4) described above, the gap may include the first gap.

(6) In the ceramic structure (4) or (5) described above, the second layer may have a porosity in a cross section parallel to the thickness direction of equal to or greater than 0.1 area% and equal to or less than 2 area%.

(7) In any one of the ceramic structures (4) to (6) described above, the second layer may include a plurality of pillar-shaped crystals inclined with respect to a surface of the first layer, and
the gap may be positioned in between the plurality of the pillar-shaped crystals that are adjacent.

(8) In any one of the ceramic structures (4) to (7) described above, the first layer may include a recess and a protrusion on a surface facing the second layer, and an end of the gap in the thickness direction may be positioned in a recessed portion of the first layer.

(9) In any one of the ceramic structures (4) to (8) described above, a length of the gap in a direction along a surface of the first layer may be smaller at a second end portion than at a first end portion in the thickness direction, the first end portion being positioned on a side of the first layer and the second end portion being apart from the first layer.

(10) In any one of the ceramic structures (4) to (9) described above, the second layer may have a larger porosity in a first portion closer to the first layer than in a second portion, the second portion being apart from the first layer than the first portion.

(11) Any one of the ceramic structures (1) to (10) described above may include an electrically conductive layer in an inner portion.

(12) Any one of the ceramic structures (1) to (11) described above may further include a third layer positioned in between the first layer and the second layer. The third layer may contain a third crystal particle, the third crystal particle being a compound identical with the second layer, and
when a half-width of a peak, the peak being same as that of the Miller index of the second crystal particle, in an X-ray diffraction of the third layer of the third crystal particle is defined as W3, W2 > W3 may be satisfied.

Further effects and variations can be readily derived by those skilled in the art. Thus, a wide variety of aspects of the present disclosure are not limited to the specific details and representative embodiments represented and described above. Accordingly, various changes are possible without departing from the spirit or scope of the general inventive concepts defined by the appended claims and their equivalents.

### REFERENCE SIGNS

1 Ceramic structure
10 First layer
11 First crystal particle
20 Second layer
21 Second crystal particle
21a Pillar-shaped crystal
22 Gap
22a First gap
22b Second gap
30 Third layer
31 Third crystal particle
40 Space
101 Surface
101a Protruding portion
101b Recessed portion
201 First surface
202 Second surface
221 First end portion
222 Second end portion

## Claims

1. A ceramic structure, comprising
a first layer containing a first crystal particle, and
a second layer positioned on the first layer, the second layer containing a second crystal particle,
the first crystal particle and the second crystal particle each comprising:
at least one metal element selected from the group consisting of Al, Si, Ti, Cr, Zr, and Y; and
at least one non-metallic element selected from the group consisting of N, C, and B,
the first crystal particle and the second crystal particle being identical compounds,
wherein, when a half-width of a peak of a Miller index of a maximum intensity of the first crystal particle in an X-ray diffraction of the first layer is defined as W1, and a half-width of a peak, the peak being the same as that of the Miller index of the second crystal particle, in an X-ray diffraction of the second layer is defined as W2,
9 × W1 > W2 > W1 is satisfied.

2. The ceramic structure according to claim 1, wherein the first crystal particle and the second crystal particle are hexagonal crystals.

3. The ceramic structure according to claim 1 or 2, wherein the first crystal particle and the second crystal particle are AlN, and
a difference between the W1 and the W2 (W2 - W1) is equal to or greater than 0.1° and equal to or less than 0.6°.

4. The ceramic structure according to any one of claims 1 to 3, wherein
the second layer comprises a gap positioned in an inner portion of the second layer, the gap is long in a thickness direction of the second layer, and both ends in the thickness direction are closed, the gap comprising at least one selected from the group consisting of: a first gap having an end in contact with the first layer in the thickness direction and a second gap having the end apart from the first layer.

5. The ceramic structure according to claim 4, wherein the gap comprises the first gap.

6. The ceramic structure according to claim 4 or 5, wherein the second layer has a porosity in a cross section parallel to the thickness direction of equal to or greater than 0.1 area% and equal to or less than 2 area%.

7. The ceramic structure according to any one of claims 4 to 6, wherein the second layer comprises a plurality of pillar-shaped crystals inclined with respect to a surface of the first layer, and
the gap is positioned in between the plurality of the pillar-shaped crystals that are adjacent.

8. The ceramic structure according to any one of claims 4 to 7, wherein the first layer comprises a recess and a protrusion on a surface facing the second layer, and
an end of the gap in the thickness direction is positioned in a recessed portion of the first layer.

9. The ceramic structure according to any one of claims 4 to 8, wherein a length of the gap in a direction along a surface of the first layer is smaller at a second end portion than at a first end portion in the thickness direction, the first end portion being positioned on a side of the first layer and the second end portion being apart from the first layer.

10. The ceramic structure according to any one of claims 4 to 9, wherein the second layer has a larger porosity in a first portion closer to the first layer than in a second portion, the second portion being apart from the first layer than the first portion.

11. The ceramic structure according to any one of claims 1 to 10, wherein an inner portion comprises an electrically conductive layer.

12. The ceramic structure according to any one of claims 1 to 11, wherein the ceramic structure further comprises a third layer positioned in between the first layer and the second layer,
the third layer comprises a third crystal particle, the third crystal particle being a compound identical with the second layer, and
when a half-width of a peak, the peak being the same as that of the Miller index of the second crystal particle, in an X-ray diffraction of the third layer of the third crystal particle is defined as W3, W2 > W3 is satisfied.
